(19) Europäisches Patentamt
European Patent Office
Office européen des brevets

(11) **EP 3 308 417 B1**

(12) **EUROPÄISCHE PATENTSCHRIFT**

(45) Veröffentlichungstag und Bekanntmachung des Hinweises auf die Patenterteilung:
**03.07.2019 Patentblatt 2019/27**

(21) Anmeldenummer: **16726267.4**

(22) Anmeldetag: **27.04.2016**

(51) Int Cl.:
*H01M 4/04* (2006.01)  *C23C 14/35* (2006.01)
*H01M 4/131* (2010.01)  *H01M 4/1391* (2010.01)
*H01M 4/58* (2010.01)  *C23C 14/06* (2006.01)
*B82Y 30/00* (2011.01)  *B82Y 40/00* (2011.01)

(86) Internationale Anmeldenummer:
**PCT/DE2016/000176**

(87) Internationale Veröffentlichungsnummer:
**WO 2016/198033 (15.12.2016 Gazette 2016/50)**

(54) **VERFAHREN ZUR HERSTELLUNG NANOSTRUKTURIERTER SCHICHTEN**

METHOD FOR PRODUCING NANOSTRUCTURED LAYERS

PROCÉDÉ DE FABRICATION DE COUCHES NANO-STRUCTURÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.06.2015 DE 102015007291**

(43) Veröffentlichungstag der Anmeldung:
**18.04.2018 Patentblatt 2018/16**

(73) Patentinhaber: **Forschungszentrum Jülich GmbH 52425 Jülich (DE)**

(72) Erfinder:
• **BÜNTING, Aiko**
**52062 Aachen (DE)**
• **UHLENBRUCK, Sven**
**50259 Pulheim (DE)**

(56) Entgegenhaltungen:
**CN-A- 103 579 623    CN-B- 103 000 879**

• LIAO C L ET AL: "Preparation of RF-sputtered lithium cobalt oxide nanorods by using porous anodic alumina (PAA) template", JOURNAL OF ALLOYS AND COMPOUNDS, ELSEVIER SEQUOIA, LAUSANNE, CH, Bd. 414, Nr. 1-2, 13. April 2006 (2006-04-13), Seiten 302-309, XP027999329, ISSN: 0925-8388, DOI: 10.1016/J.JALLCOM.2005.07.042 [gefunden am 2006-04-13]

• HWANG B J ET AL: "Template-free reverse micelle process for the synthesis of a rod-like LiFePO4/C composite cathode material for lithium batteries", JOURNAL OF POWER SOURCES, ELSEVIER SA, CH, Bd. 194, Nr. 1, 20. Oktober 2009 (2009-10-20), Seiten 515-519, XP026446374, ISSN: 0378-7753 [gefunden am 2009-05-20]

• GINTS KUCINSKIS ET AL: "Kinetic Behavior of LiFePO4/C Thin Film Cathode Material for Lithium-Ion Batteries", SCIENTIFIC JOURNAL OF RIGA TECHNICAL UNIVERSITY. ENVIRONMENTAL AND CLIMATE TECHNOLOGIES, Bd. 4, Nr. -1, 1. Januar 2010 (2010-01-01) , XP055283888, ISSN: 1691-5208, DOI: 10.2478/v10145-010-0018-3

• AIKO BÜNTING ET AL: "Three-Dimensional, Fibrous Lithium Iron Phosphate Structures Deposited by Magnetron Sputtering", ACS APPLIED MATERIALS AND INTERFACES, Bd. 7, Nr. 40, 18. September 2015 (2015-09-18), Seiten 22594-22600, XP055283674, US ISSN: 1944-8244, DOI: 10.1021/acsami.5b07090

• Aiko Bünting: "Herstellung von Elektrodenstrukturen für Lithium-Ionen-Dünnschichtbatterien", chriften des Forschungszentrums Jülich Reihe Energie & Umwelt , Bd. 151 26. August 2015 (2015-08-26), XP055283950, ISBN: 978-3-95806-073-9 Gefunden im Internet: URL:http://juser.fz-juelich.de/record/2034 72 [gefunden am 2016-06-27]

**Beschreibung**

Die Erfindung betrifft ein Verfahren zur Herstellung von nanostrukturierten Schichten, insbesondere von nanostrukturierten Elektroden, die in Batterien und anderen elektrochemischen Zellen eingesetzt werden können.

Stand der Technik

Nanostrukturierte Materialien sind in der Regel aus Nanopartikeln aufgebaut. Diese NanoPartikel umfassen typischerweise einige wenige hundert Atome oder Moleküle, die diskrete Einheiten bilden. Sie weisen entlang wenigstens einer Dimension eine Größe im Nanometerbereich, bzw. kleiner als 100 nm auf. Nanostrukturierte Materialien zeigen häufig veränderte Eigenschaften im Vergleich zu den Eigenschaften derselben Verbindung mit deutlich größeren Abmessungen, z. B. im Mikrometerbereich. Sie weisen insbesondere ein großes Oberflächen-zu-Volumenverhältnis auf. Weitere kennzeichnende Eigenschaften von nanostrukturierten Materialien sind eine hohe mechanische Stabilität sowie Toleranz gegenüber Volumenänderungen.

Unter anderem aus dem vorgenannten Grund eignen sich nanostrukturierte Materialien besonders für den Einsatz als Elektroden in Batterien. Durch das große Oberflächen-zu-Volumen-Verhältnis ist die Kontaktfläche zwischen Elektrolyt und Elektrode vorteilhaft erhöht und die Wegstrecke für den Ionen-Transport in das Material reduziert. Dadurch können nanostrukturierte Elektrodenmaterialien regelmäßig eine höhere Leistungsfähigkeit erreichen und Polarisationsverluste verringern. Ferner weisen nanostrukturierte Elektroden eine hohe Stabilität gegenüber der Einlagerung von Ionen und der damit verbundenen nachteiligen Volumenänderung auf, so dass die Langlebigkeit der Batterien erhöht werden kann.

Die bislang gängigste Herstellungsmethode für nanostrukturierte Schichten bzw. Beschichtungen beruht auf nasschemischen Verfahren. Dazu gehören insbesondere die Hydro-/ Solvothermalsynthese, Sol-Gel-Prozesse, Mikroemulsionssynthesen oder auch die elektrochemische Deposition.

Bei diesen Verfahren werden regelmäßig die als Nanomaterialien hergestellten Aktivmaterialien, Leitfähigkeitszusätze und Bindemittel enthaltende Beschichtungszusammensetzungen bzw. -dispersionen auf leitfähige Folien als Stromsammler beschichtet. Bei der Herstellung entsprechender Dispersionen kann sowohl auf Wasser als auch auf organische Lösungsmittel zurückgegriffen werden.

In B.-J. Hwang et al., "Template-free reverse micelle process for the synthesis of a rod-like LiFePO4/C composite cathode material for lithium batteries", Journal of Power sources, Elsevier SA, CH, Bd. 194, Nr. 1, 20. Oktober 2009 (2009-10-20), Seiten 515-519, wird über ein Verfahren zur Synthese von stabförmigen $LiFePO_4$/C-Kathoden nach dem schablonenfreien Reverse-Mizellen-Verfahren berichtet. Es wurde herausgefunden, dass die stabförmige nanostrukturierte Morphologie die Strukturstabilität, die Lithiumionendiffusion und die elektronische Leitfähigkeit des $LiFePO_4$/C-Verbundmaterials deutlich verbessert.

Nachteilig kann sich die Viskosität der Beschichtungssuspension jedoch im Verlauf von mehreren Stunden ändern, beispielsweise durch nicht perfekt geeignete Suspensionszusammensetzung. Beispielsweise kann es zu einer chemischen Reaktion zwischen Komponenten der Suspension kommen. Die bislang bekannten geeigneten organischen Lösungsmittel für die Herstellung von Elektroden haben zudem teilweise den Nachteil, dass sie als giftig eingestuft werden.

Mit Hydro-/Solvothermalsynthese, Sol-Gel-Prozesse oder auch elektrochemischer Deposition ist es auch möglich, direkt "selbstragende" Strukturen, das bedeutet Strukturen ohne Bindemittel, herzustellen.

Im Rahmen der Erfindung werden unter nasschemischen Verfahren im weiteren Sinne aber auch solche Verfahren verstanden, bei denen mit den vorgenannten Verfahren zunächst Pulver hergestellt werden. Diese werden im Anschluss über pulvertechnologische Verfahren, wie beispielsweise Gießverfahren oder Druckverfahren, insbesondere auch unter Zuhilfenahme von Hilfsstoffen, z. B. Flüssigkeiten, insbesondere Lösungsmitteln, Bindemitteln, Dispergiermitteln, Oberflächenentspannern oder Entschäumern, zu Schichten verarbeitet. Die Mischung aus Pulvern mit solchen Hilfsstoffen für die weitere Verarbeitung nennt man auch Schlicker.

So ist aus CN 103000879 B ein nasschemisches Herstellungsverfahren für ein Spinell-Lithium-Nickel-Mangan-Oxid bekannt, bei dem eine Mangansalzlösung mit Oxalsäure- oder Ammoniumoxalatlösung vermischt und zur Reaktion gebracht wird. Das Manganoxalat wird abgeschieden und getrocknet und zu Manganoxalat-Mikrostäbchen mit einer eindimensionalen Struktur kalziniert. Anschließend werden diese mit einer Lithiumquelle und einer Nickelquelle gleichmäßig vermischt. Erneutes Kalzinieren der erhaltenen Mischung bei hoher Temperatur führt zu einem Lithium-Nickel-Manganoxid vom Spinell Typ mit der eindimensionalen porösen Struktur.

Auch mit den oben genannten Verfahren können nanostrukturierte Materialien erzeugt werden. Nachteilig sind diese erzeugten nanostrukturierten Materialien freistehend, also nicht bereits auf einem leitfähigen Substrat angeordnet. Daher muss regelmäßig in einem zweiten Verfahrensschritt ein Elektrodenschlicker, bestehend aus den zuvor hergestellten nanostrukturierten Aktivmaterialien, Leitfähigkeitszusätzen und Bindemitteln, hergestellt und auf die leitfähige Folie bzw. das leitfähigen Substrat aufgebracht werden.

Hierbei kann es nachteilig zu einer Agglomeration der Nanopartikel kommen, wodurch ihre kennzeichnenden Eigenschaften häufig verloren gehen. Ferner enthält der Elektrodenschlicker Binder und in der Regel auch zusätzlichen leitfähigen Kohlenstoff, wodurch die spezifische Energie der Batterie, in der die so hergestellte Elektrode eingesetzt wird, in der Regel nachteilig reduziert wird.

Die Herstellung von nanostrukturierten Materialien als Beschichtungen über den nasschemischen Ansatz im weiteren Sinne findet also in der Regel über mehrere Prozessschritte statt. Hierbei sowie bei der chemischen Abscheidung aus der Gasphase werden zum Teil giftige Ausgangsstoffe, Dispergier-, Binde- bzw. Lösungsmittel verwendet. Ferner werden bei diesen Verfahren zum Teil Masken oder Schablonen, sogenannte "templates", und Katalysatoren benötigt.

Ein solches Beschichtungsverfahren zur Herstellung von nanostrukturierten Elektroden für elektrische Energiespeicher unter Verwendung eines speziellen Lösungs- und/oder Dispersionsmittels ist beispielsweise aus DE 10 2009 034 799 A1 bekannt.

Neueste Entwicklungen zeigen, dass nanostrukturierte Elektroden, die über selbsttragende Techniken, d. h. also ohne Zusätze und Binder, hergestellt werden, vielfach Vorteile gegenüber den nasschemisch hergestellten Elektroden aufweisen, insbesondere bezüglich ihrer Oberflächenbeschaffenheit und ihrer verbesserten elektronischen Transporteigenschaften. In B. L. Ellis, P. Knauth, T. Djenizian, Three-dimensional self-supported metal oxides for advanced energy storage, Advanced Materials 2014, 26(21), 3368 - 3397 wird eine Übersicht über die Rolle von 3D selbsttragenden nanostrukturierten Oxiden als Elektroden und Elektrolytmaterial für die Energiespeicherung gegeben. Unter einer selbsttragenden Elektrode wird dabei verstanden, dass elektroaktives Material direkt auf einem leitfähigen Substrat aufwächst, und dadurch Additive und Binder vermieden werden können, wie sie bei größeren Elektroden häufig im Elektrodenschlicker zu finden sind.

Weiterhin ist das Magnetron-Sputtern als eine Herstellungsmethode zur Abscheidung von vielfältigen Beschichtungen bekannt, bei dem im Allgemeinen eine relativ dichte Beschichtung auf einen Träger aufgebracht werden kann. Beim Sputtern, auch Kathodenzerstäubung genannt, werden Atome, Ionen bzw. Cluster davon aus einem Festkörper (das sogenannte Target) durch Beschuss mit energiereichen Ionen (vorwiegend Edelgasionen) herausgelöst und in die Gasphase überführt, die sich anschließend auf der Oberfläche eines zu beschichtenden Substrates abscheiden. Ein solches Herstellungsverfahren wird häufig für dichte harte, verschleißfeste, reibungsarme, korrosionsfeste oder schmückende Beschichtungen oder Beschichtungen mit speziellen optischen oder elektrischen Eigenschaften angewandt, wie aus "Magnetron sputtering: a review of recent developments and applications", P. J. Kelly, R. D. Arnell, Vacuum, Volume 56, Issue 3, March 2000, Pages 159-172 bekannt ist.

Die Struktur einer über das Magnetron-Sputtern abgeschiedenen Schicht ist insbesondere abhängig von den Verfahrensparametern Temperatur und Druck. Am Beispiel von Metallen konnte gezeigt werden, dass sich im Allgemeinen beim Sputtern mit zunehmender Temperatur eine dichtere Schicht ausbildet.

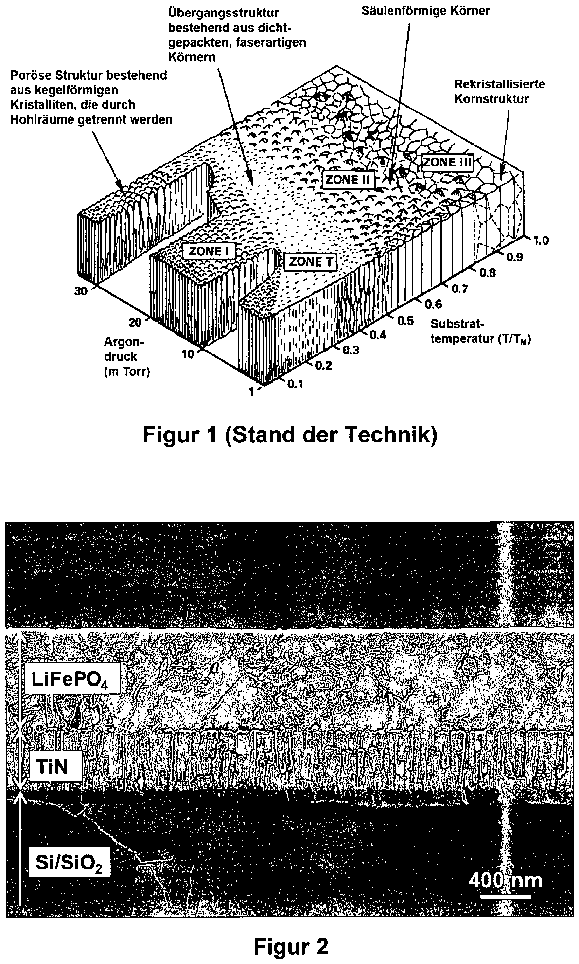

Zur Beschreibung dieses Verhaltens wurde ein sogenanntes Struktur-Zonen-Modell entwickelt, welches in Figur 1 gezeigt und aus "Influence of substrate temperature and deposition rate on structure of thick sputterd Cu coatings von Thornton, J. A., Journal of Vacuum Science & Technology, 1975. 12(4): p. 830-835 entnommen ist.

Aus "Thin film microstructure control using glancing angle deposition by sputtering", J. C. Sit, D. Vick, K. Robbie, M. J. Brett, Journal of Materials Research 14 (04), 1197 - 1199 ist ferner bekannt, dass definiert nanostrukturierte Beschichtungen auch über ein Sputterverfahren erzeugt werden können. Das Ausgangsmaterial der Materialquelle wird hierbei durch einen Zerstäubungsprozess, thermisches Verdampfen oder eine Laserbestrahlung in die Gasphase überführt. Zur Erzeugung der definiert nanostrukturierten Beschichtungen ist allerdings ein besonderer Versuchsaufbau notwendig, bei dem das Substrat gegenüber der Ausgangsmaterialquelle in einem Winkel $\alpha$ (verkippt) zum Einfallswinkel des zerstäubten Substrats angeordnet ist, wobei $\alpha$ typischerweise sogar mehr als 80° beträgt. Gleichzeitig kann das Substrat selbst während der Deposition über einen Schrittmotor eine Rotation um eine Achse senkrecht zur Substratoberfläche durchführen. Die Abscheidung des Materials in Form von Säulen findet somit unter schrägem/streifenden Einfall statt.

Aus C. L. Liao et al., "Preparation of RF-sputtered lithium cobalt oxide nanorods by using porous anodic alumina (PAA) template", JOURNAL OF ALLOYS AND COMPOUNDS, ELSEVIER SEQUOIA, LAUSANNE, CH, Bd. 414, Nr. 1-2, 13. April 2006 (2006-04-13), Seiten 302-309, ist ein Verfahren zur Herstellung einer nanostrukturierten Elektrode für eine elektrochemische Zelle bekannt, bei dem Aktivmaterial auf ein elektrisch leitendes Substrat aufgebracht wird, wobei das Aktivmaterial in einem Prozessschritt mit Hilfe des Magnetron-Sputterns auf dem elektrisch leitenden Substrat abgeschieden wird und wobei ein keramisches Target, umfassend ein Elektrodenmaterial, eingesetzt wird.

Auch in CN 103 579 623 A wird über ein Verfahren zur Herstellung von Lithiumphosphat-Elektrodenmaterial für Batterien mittels Magnetron-Sputterns berichtet.

Das Verfahren ist auch unter dem Begriff "glancing angle deposition" (GLAD) bekannt. Der Einfallswinkel $\alpha$ beeinflusst dabei maßgeblich den Zwischenraum zwischen den säulenförmigen Abscheidungen und damit die Porosität des abgeschiedenen Films. Zur Erzielung eines porösen, kontrolliert mikrostrukturierten Films ist es daher notwendig, für das zerstäubte Material eine sehr enge Winkelverteilung einstellen zu können. Die bislang erzielten Strukturen weisen beispielsweise zick-zack förmige, spiralförmig (helixförmig) gedrehte oder säulenförmige Mikrostrukturen auf.

Nachteilig bei der bisherigen Herstellung von nanostrukturierten Materialien mittels physikalischer Gasphasenabscheidung unter schrägem Einfall ist ein sehr aufwändiger Versuchsaufbau, der in der Regel mit Einbußen in der Abscheidungsrate verbunden ist. Zudem ist die Beschichtung auf Bereiche mit kleiner Fläche eingeschränkt.

Aufgabe und Lösung der Erfindung

Aufgabe der vorliegenden Erfindung ist es, ein Verfahren zur Herstellung von nanostrukturierten Elektroden für elektrische Energiespeicher, insbesondere für Lithiumionen-Zellen, bereitzustellen, welches die aus dem Stand der Technik bekannten Nachteile überwindet. Die Aufgabe der Erfindung ist es insbesondere, solche nanostrukturierte Elektroden vorzugsweise in einem einzigen Prozessschritt zu erzeugen und bereit zu stellen.

Gelöst wird diese Aufgabe der Erfindung in überraschender Weise dadurch, dass die Herstellung von nanostrukturierten Elektroden mittels physikalischer Gasphasenabscheidung über eine Magnetron-Sputteranlage mittels eines keramischen Targets gemäß der Merkmale des Hauptanspruchs erfolgt. Die nanostrukturierten Elektroden mit Ihren kennzeichnenden Merkmalen ergeben sich aus den Nebenansprüchen.

Vorteilhafte Ausgestaltungen des Herstellungsverfahrens sowie der nanostrukturierten Elektroden finden sich in den darauf rückbezogenen Unteransprüchen.

Gegenstand der Erfindung

Das erfindungsgemäße Herstellungsverfahren für nanostrukturierte Materialien sieht in seiner breitesten Anwendungsmöglichkeit vor, dass ein Träger (Substrat) mit wenigstens einem Beschichtungsmaterial mit Hilfe der Methode des Magnetron-Sputterns beschichtet wird.

Im Unterschied zu den bekannten Sputterverfahren und insbesondere dem "glancing angle deposition" (GLAD)-Verfahren, wurde im Rahmen der Erfindung herausgefunden, dass mit Hilfe des Magnetron-Sputterns unter bestimmten Voraussetzungen eine nanostrukturierte Schicht abgeschieden werden kann, die nicht die üblichen kolumnaren Strukturen, d. h. säulenartige Strukturen mit einer Vorzugsrichtung senkrecht zur Oberfläche aufweist, sondern dass ein nanostrukturiertes, faserförmiges, feinverzweigtes Netzwerk (netzartige Nanostrukturierung) ohne eine besondere Vorzugsrichtung erzeugt werden kann. Hierdurch kann eine sonst häufig auftretende Agglomeration des abgeschiedenen Materials vorteilhaft verhindert werden.

Die erfindungsgemäße Nanostrukturierung des Aktivmaterials weist regelmäßig eine faserartige nanoskalige Netzstruktur auf.

Das Aktivmaterial selbst weist vorzugsweise eine Porosität zwischen 20 und 90 % auf.

Für die erfindungsgemäße Erzeugung der netzartigen Nanostrukturierung ist es grundlegend notwendig, dass neben den üblichen Prozessparametern für das Sputterverfahren, wie Prozessleistung, Prozessgas, Prozessdruck und Gasfluß, erfindungsgemäß die Substrattemperatur gezielt eingestellt wird. Hierbei ist es insbesondere wichtig, dass die Substrattemperatur während der Abscheidung ausreichend hoch, das bedeutet größer als 400 °C, vorzugsweise sogar höher als 500 °C eingestellt wird.

Das erfindungsgemäße Herstellungsverfahren sieht in einer besonderen Ausgestaltung vor, dass ein elektrisch leitfähiger Träger (Substrat) mit wenigstens einem Aktivmaterial mit Hilfe der Methode des Magnetron-Sputterns beschichtet wird. Diese aufgebrachte Schicht kann dann beispielsweise die Funktion einer Elektrodenfunktionsschicht in einer elektrochemischen Zelle übernehmen.

Unter einem Sputterverfahren wird im Rahmen dieser Erfindung insbesondere die Kathodenzerstäubung verstanden, bei der in einem physikalischen Vorgang Atome, Ionen, bzw. Cluster aus einem Festkörper (Target) durch Beschuss mit energiereichen Ionen (vorwiegend Edelgasionen) herausgelöst werden und in die Gasphase übergehen.

Unter einer Sputterdeposition wird im Rahmen dieser Erfindung eine Beschichtung bzw. ein Beschichtungsvorgang verstanden, welche zur Gruppe der Verfahren der physikalischen Gasphasenabscheidung (engl. physical vapour deposition = PVD) zählt. Dabei wird mit Hilfe eines Sputterverfahrens zunächst Material von einem Target zerstäubt und in die Gasphase überführt, welche sich im Anschluss auf einem Substrat niederschlägt und eine feste Schicht ausbildet. Im Bereich der Beschichtungstechnik wird die Sputterdeposition häufig nur als "Sputtern" bezeichnet.

Je nach Ausgestaltung des Verfahrens erfolgt die Zerstäubung des Targetmaterials in Atome, Ionen oder auch größere Cluster oder auch anteilig in allen drei Formen. Das zerstäubte Material bewegt sich entweder ballistisch oder bei geladenen Teilchen durch elektrische Felder geführt durch die Sputterkammer und trifft dabei auf die zu beschichtenden Teile (Substrat), wo es auf der Oberfläche des Substrats zur Ausbildung einer Schicht kommt.

Die zum Sputtern notwendigen Ionen werden im Allgemeinen durch Stoßionisationsvorgänge infolge elektrischer Felder erzeugt. Mit einem Sputterverfahren mit einem konstanten elektrischen Felde und einem daraus resultierenden Gleichstrom ("DC-Sputtern") können in der Regel fast alle Metalle, Halbmetalle und auch Kohlenstoff in sehr reiner Form abgeschieden werden. Sofern man während des Verfahrens zusätzlich noch Reaktivgase wie Sauerstoff, Stickstoff oder Kohlenwasserstoffe zuführt, können auch die entsprechenden Oxide, Nitride oder Carbide abgeschieden werden.

Weiterhin ist es möglich, nicht-leitende keramische Materialien abzuscheiden. Hierbei ist es grundsätzlich nötig, den Prozess mit einer hochfrequenten Wechselspannung und daraus resultierend einem Wechselstrom zu betreiben ("RF-Sputtern"), um ein Aufladen des Targets zu vermeiden. Alternativ kann auch ein (bipolarer) Spannungspuls (d. h. ein elektrischer Puls zur Gasionisation, Stromleitung und Sputterdeposition, dem sich ggf. ein weiterer Spannungspuls zur Entladung der Targetoberfläche anschließt) verwendet werden ("pulsed sputtering").

Mit den vorgenannten Sputterverfahren können vorwiegend dünne Schichten im Bereich einiger Nanometer bis hin zu einigen Mikrometern, beispielsweise von 50 nm bis 100 $\mu$m, auf einem Substrat abgeschieden werden. Bei dichten Schichten nehmen mit zunehmender Schichtdicke die Eigenspannungen regelmäßig innerhalb der Schichten zu. Dies führt häufig zur Ablösung der aufgebrachten Schicht vom Substrat (Delamination) und ist einer der Gründe, weshalb sich mit einem Sputterverfahren in der Regel nicht beliebig dicke Schichten herstellen lassen.

Unter einem Aktivmaterial wird im Rahmen der Erfindung allgemein ein Material verstanden, welches die reversible Ein- und -Auslagerung elektrisch geladener Teilchen in elektrochemischen Zellen ermöglicht.

Im Falle einer Lithium-Ionen-Zelle handelt es sich bei den elektrisch geladenen Teilchen in der Regel um Lithium-Ionen. Die Einlagerungs- und Auslagerungsvorgänge finden beim Laden bzw. Entladen jeweils an der Kathode und an der Anode statt. Für die Herstellung von Anode und Kathode werden in der Regel jeweils verschiedene Aktivmaterialien verwendet.

Im erfindungsgemäßen Verfahren wird daher ein Target aus einem Aktivmaterial (Kathoden oder Anodenmaterial) eingesetzt, welches vorzugsweise ausgewählt ist aus der Gruppe umfassend

- Graphit,
- amorphe Kohlenstoffe (z. B. Hard Carbon, Soft Carbon),
- Lithium-Speichermetalle, -halbmetalle und -legierungen, inkl. Halbleiter (z. B. nanokristallines oder amorphes Silizium und Silizium-Kohlenstoff-Komposite, Sn, Al, Sb),
- $Li_4Ti_5O_{12}$ oder Mischungen dieser Materialien mit weiteren Aktivmaterialien oder mit Lilonenleitern bzw. Elektronenleitern,
- Lithiummetalloxide vom Typ $LiM_xO_2$ mit M = Co, Ni, Mn, Al, (z. B. $LiCoO_2$, $LiMnO_2$, $LiNiO_2$, $LiNi_{1-x}Co_xO_2$, $LiNi_{0,85}Co_{0,1}Al_{0,05}O_2$, $Li_{1+x}(Ni_yCo_{1-2y}Mn_y)_{1-x}O_2$, insbesondere mit $0 \leq x \leq 0,17$ und $0 \leq y \leq 0,5$),
- $LiMn_2O_4$ Spinell, auch teilsubstituiert mit anderen Ionen,
- Lithiummetallphosphate vom Typ $LiMPO_4$ mit M = Fe, Mn, Co, V ggfs. auch mit Zugabe von Kohlenstoff (z. B. $LiFePO_4$, $LiMnPO_4$, $LiCoPO_4$, $LiVPO_4$) auch teilsubstituiert mit anderen Ionen, sowie
- Konversionsmaterialien wie Eisen(III)fluorid ($FeF_3$) oder
- $V_2O_5$.

Besonders geeignet für das erfindungsgemäße Aufbringungsverfahren sind insbesondere solche Materialien, die eine große Volumenschwankung während der Ein- oder Auslagerung eines elektrochemischen Prozesses erfahren.

Als Aktivmaterialien sind im Rahmen dieser Erfindung zudem auch Mischungen dieser vorgenannten Materialien geeignet. Insbesondere keramische Targets, die mit Kohlenstoff (Soft/ Hard Carbon) vermischt sind, sind für die Herstellung von nanostrukturierten Schichten geeignet. Unter Soft Carbon versteht man dabei nicht-graphitische Kohlenstoffe, die sich bei hohen Temperaturen von bis zu 3200 °C in Graphit umwandeln. Unter Hard Carbon versteht man nicht-graphitische Kohlenstoffe, die sich bei den im Stand der Technik realisierten Temperaturen nicht in Graphit umwandeln. Als Substitutionselemente für die Lithiummetallphosphate kommen z. B. Magnesium oder Niob, bzw. deren Ionen, in Frage.

Als elektrisch leitfähige Substrate sind dabei alle gängigen Elektrodensubstrate geeignet, die mechanisch und thermisch bis zu Temperaturen von wenigstens 400 °C, vorzugsweise bis 500 °C stabil sind. Dabei spielt unter anderem auch die gewählte Abscheidetemperatur eine Rolle.

Anders als bei den bislang bekannten nasschemischen Verfahren muss das Aktivmaterial für die Elektroden nicht zuvor als Pulver mit Partikeln mit Abmessungen im Mikrometer-, Submikrometer bzw. Nanometerbereich ("Mikrobzw. Nano-Pulver") bereit gestellt werden, sondern es kann im Rahmen des erfindungsgemäßen Herstellungsverfahrens über einen Sputterprozess von einem Target direkt auf der Oberfläche des Substrates in Form von Nano-Partikeln abgeschieden werden. Auch andere Vorbehandlungen, wie das Aufbringen von Masken, sind nicht erforderlich.

Dadurch kann vorteilhaft in nur einem einzigen Arbeitsschritt die gewünschte, poröse, netzförmig nano-strukturierte Schicht erzeugt werden, die dann die Funktion einer Elektrodenfunktionsschicht übernehmen kann. Weitere Nachbehandlungen, wie beispielsweise das Entfernen von Masken, ein Kristallisationsschritt oder eine Trocknung, bzw. ein Ausbrennen von Platzhaltern, ist ebenfalls bei dem erfindungsgemäßen Verfahren nicht vorgesehen.

Anders als bei dem bislang bekannten GLAD Verfahren ist es erfindungsgemäß auch nicht notwendig, dass das Substrat gegenüber der Ausgangsmaterialquelle (Target) in einem Winkel $\alpha$ (verkippt) zum Einfallswinkel des zerstäubten Substrats angeordnet werden muss. Dadurch kann vorteilhaft auf einen aufwändigen Herstellungsaufbau verzichtet werden.

Die Prozessparameter beim Magnetron-Sputtern sollten bei dem erfindungsgemäßen Verfahren in einem bestimmten Rahmen eingehalten werden. Dazu gehören beispielsweise:

| | |
|---|---|
| Prozessdruckbereich: | $1 \cdot 10^{-3}$ mbar bis $5 \cdot 10^{-2}$ mbar, |
| Prozessleistung: | 0,5 bis 4 $W/cm^2$, insbesondere 1,0 bis 3 $W/cm^2$, |
| Prozessgas: | insbesondere Argon, aber auch Argon/Sauerstoff, Argon/Stickstoff, Argon/Wasserstoff oder Argon/ Kohlenwasserstoffe, |
| Glasfluss: | 5 bis 140 sccm, insbesondere 10 bis 50 sccm, entspricht $8,3 \cdot 10^{-8}$ - $233 \cdot 10^{-8}$ $m^3$ $s^{-1}$, insbesondere $16,6 \cdot 10^{-8}$ - $83 \cdot 10^{-8}$ $m^3$ $s^{-1}$ |
| Abscheideraten: | 0,05 bis 10 mg$\cdot$ h/$cm^2$, insbesondere 0,2 bis 0,5 mg h/$cm^2$, |
| Schichtdickenbereich: | 50 nm bis 100 $\mu$m. |

Wird der Prozessdruck zu hoch eingestellt, wird regelmäßig keine nanoskalige Faserstruktur mehr erhalten, sondern eine ebene Dünnschicht. Umgekehrt verhält es sich bei zu geringen Drücken. Das Plasma ist nicht mehr stabil und kann zusammenbrechen.

Die Prozessleistung wirkt sich linear auf die Abscheiderate aus, d. h. je höher die Prozessleistung, desto höher die Abscheiderate. Daher ist eine möglichst hohe Leistung wünschenswert. Bei zu hohen Leistungen kann jedoch das Target zerstört werden.

Bei Verwendung von Argon findet bei der Abscheidung keine Reaktion statt und das Ausgangsmaterial wird im Idealfall unverändert abgeschieden. Bei Verwendung von Reaktivgasen tritt eine Reaktion auf, wodurch sich die Zusammensetzung des abgeschiedenen Materials ändert.

Der Gasfluß spielt nur eine untergeordnete Rolle. Er sollte jedoch hinreichend groß eingestellt werden, damit in der verwendeten Sputterkammer der gewünschte Prozessdruck erreicht werden kann.

Im vorliegenden Fall wird eine vergleichsweise hohe Abscheiderate erhalten, die möglicherweise mit entscheidend für die Ausbildung der netzartigen Nanostruktur ist.

Die Schichtdicken der abgeschiedenen Schichten lagen typischerweise im Bereich von 50 nm bis 100 $\mu$m. Die Abscheidezeit variiert dabei zwischen 10 Minuten und 10 Stunden, insbesondere zwischen 1 und 5 Stunden.

Wesentlich für die Ausbildung der netzartig porösen Nanostrukturierung bei dem abgeschiedenen Material sind allerdings:

| | |
|---|---|
| Temperaturbereich des Substrates: | 400 °C, vorzugsweise 500 °C bis 1200 °C, |
| Kohlenstoffgehalt des Targets: | 0,1 bis 25 Gew.-%, insbesondere 2 bis 7 Gew.-% |

Die Erfindung betrifft ein Verfahren zur Herstellung einer nanostrukturierten Elektrode für eine elektrochemische Zelle, bei dem Aktivmaterial auf ein elektrisch leitendes Substrat aufgebracht wird, wobei das Aktivmaterial in einem Prozessschritt mit Hilfe des Magnetron-Sputterns auf das elektrisch leitende Substrat abgeschieden wird, ein keramisches Target umfassend ein Kathodenmaterial mit einem zusätzlichen Anteil an Kohlenstoff eingesetzt wird, und wobei das Substrat während der Abscheidung auf Temperaturen zwischen 400 °C und 1200 °C gehalten wird.

Bei dem Verfahren wird als Aktivmaterial insbesondere $LiFePO_4$, $Li_4Ti_5O_{12}$, Lithiummetalloxide vom Typ $LiM_xO_2$ mit M = Co, Ni, Mn, Al, $LiMn_2O_4$ -Spinelle, auch teilsubstituiert, Lithiummetallphosphate vom Typ $LiMPO_4$ mit M = Fe, Mn, Co, V, auch teilsubstituiert, $V_2O_5$ oder Konversionsmaterialien, wie $FeF_3$ eingesetzt.

Bei dem Verfahren wird der zusätzliche Anteil an Kohlenstoff im Target vorzugsweise zwischen 0,1 und 25 Gew.-% gewählt, insbesondere zwischen 2 und 7 Gew.-%.

Bei dem Verfahren wird vorzugsweise Argon, Argon/ Sauerstoff, Argon/Stickstoff, Argon/Wasserstoff oder Argon/Kohlenwasserstoffe als Arbeitsgas eingesetzt.

Bei dem Verfahren wird bevorzugt eine Leistungsdichte von 0,5 bis 2 $W/cm^2$, insbesondere eine Leistungsdichte von 1,0 bis 1,5 $W/cm^2$ in der Prozesskammer eingestellt.

Bei dem Verfahren wird vorzugsweise ein Gasfluß von 5 bis 50 sccm, insbesondere ein Gasfluß von 10 bis 25 sccm in der Prozesskammer eingestellt.

Bei dem Verfahren wird bevorzugt eine Abscheiderate von 0,1 bis 1 mg$\cdot$h/$cm^2$ eingestellt, insbesondere eine Abscheiderate von 0,2 bis 0,5 mg$\cdot$h/$cm^2$.

Bei dem Verfahren erfolgt die Abscheidung zwischen 10 Minuten und 10 Stunden, insbesondere zwischen 1 und 5 Stunden.

Die Erfindung betrifft zudem eine nanostrukturierte Elektrode für eine elektrochemische Zelle, umfassend eine Beschichtung aus einem Aktivmaterial auf einem elektrisch leitenden Substrat, wobei das nanostrukturierte Aktivmaterial eine poröse Struktur aufweist, die keine Vorzugsrichtung senkrecht zur Substratoberfläche aufweist.

Das nanostrukturierte Aktivmaterial der Elektrode weist vorzugsweise eine faserartige Struktur auf, wobei die Fasern einen Durchmesser im Bereich von 10 bis 500 nm, insbesondere im Bereich zwischen 10 und 200 nm aufweisen.

Die nanostrukturierte Elektrode umfassend bevorzugt $LiFePO_4$, $Li_4Ti_5O_{12}$, Lithiummetalloxide vom Typ $LiM_xO_2$ mit M = Ni, Co, Mn, Al, $LiMn_2O_4$-Spinelle, auch teilsubstituiert, Lithiummetallphosphate vom Typ $LiMPO_4$ mit M = Fe, Mn, Co, V, auch teilsubstituiert, $V_2O_5$ oder Konversionsmaterialien wie $FeF_3$ als Aktivmaterial.

Bei der nanostrukturierten Elektrode weist das Aktivmaterial vorzugsweise eine Porosität zwischen 20 und 90 % auf.

Die nanostrukturierte Elektrode kann vorteilhaft nach den vorgenannten Verfahren hergestellt werden.

Spezieller Beschreibungsteil

Die Erfindung wird nachfolgend anhand von Ausführungsbeispielen und Figuren näher erläutert, ohne dass dadurch eine Einschränkung erfolgt.

Die Herstellung der nanostrukturierten Elektrode erfolgt mittels eines Magnetron-Kathodenzerstäubens (Magnetron-Sputtering) ohne Verwendung einer Maske/Schablone und ohne Einsatz eines Katalysators. Bei der Herstellung der nanostrukturierten Elektroden werden weder giftige Ausgangsmaterialien noch Lösungsmittel benötigt.

Die erfindungsgemäße nanostrukturierte Elektrode ist im Rahmen der Erfindung definiert als eine Elektrode, die z. B. mit einem Elektronenmikroskop auflösbare Strukturen mit Abmessungen im Nanometerbereich ohne besondere Vorzugsrichtung aufweist.

Das Ausgangsmaterial für die Herstellung (Target) wird in die Gasphase überführt und kondensiert anschließend vorteilhaft unter den erforderlichen Prozessbedingungen in der gewünschten nanostrukturierten Form. Bei der Zugabe von Kohlenstoff im Target hat sich jedoch herausgestellt, dass der Kohlenstoff selbst nicht mit abgeschieden wird, die Abscheidung des Aktivmaterials in Bezug auf die Struktur aber entscheidend beeinflusst.

Die Abscheidung des Ausgangsmaterials kann vorteilhaft direkt auf einen Stromsammler erfolgen, wodurch zusätzliche Prozessschritte zur Erstellung und Aufbringung eines Elektrodenschlickers auf den Stromsammler entfallen und die nanostrukturierte Elektrode zudem keine Binder enthält.

Allgemein zeichnen sich Schichten, die mittels Magnetron-Sputterns hergestellt wurden, dadurch aus, dass sie sehr dicht sind.

In der Figur 2 sind dazu dichte TiN- und $LiFePO_4$-Schichten auf einem Siliziumträger dargestellt, wie sie beispielsweise aus J. A. Thornton "Influence of substrate temperature and deposition rate on structure of thick sputtered Cu coatings", Journal of Vacuum Science & Technology, 1975. 12(4): p. 830-835 bekannt sind, und die mittels Magnetron-Sputterns aufgebracht worden sind.

Wenn beim Magnetron-Sputtern poröse Strukturen entstehen, dann entstehen sie in der Regel nur bei niedrigen Temperaturen, das bedeutet bei Raumtemperatur oder bei Temperaturen bis zu einigen hundert Grad, da hier eine geringe Oberflächendiffusion vorliegt, wie aus Mahieu, S., et al., "Biaxial alignment in sputter deposited thin films", Thin Solid Films, 2006. 515(4): p. 1229-1249 bekannt ist. Bei Erhöhung der Temperatur nimmt die Porosität der Schicht regelmäßig ab, da verstärkt Diffusionsvorgänge zu einer dichteren Morphologie führen.

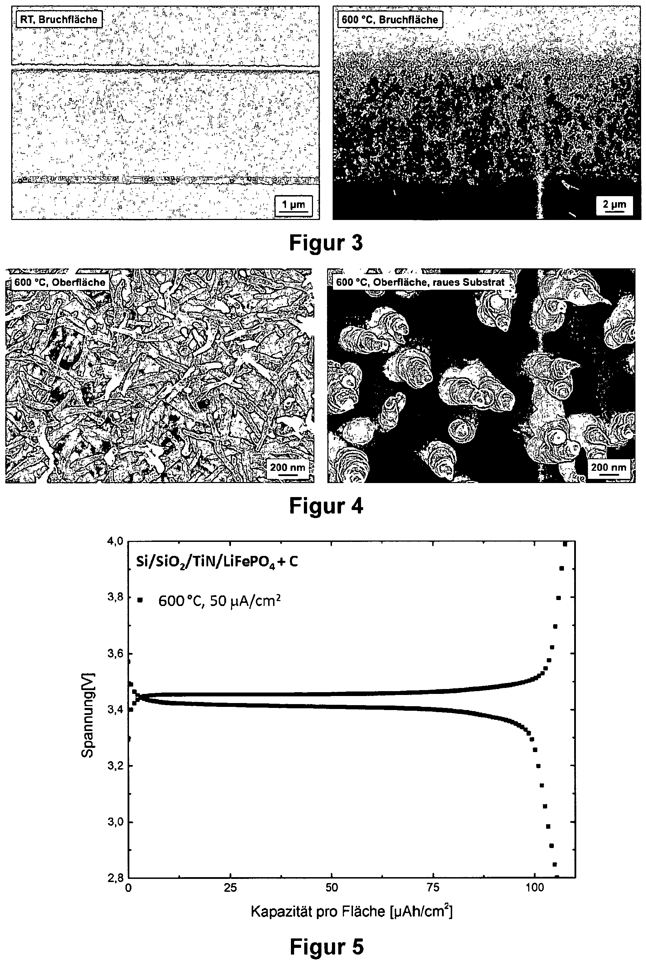

Bei dem vorliegenden erfindungsgemäßen Verfahren liegt jedoch ein gegenläufiges Verhalten vor. Bei der Magnetron-gesputterten Abscheidung einer $LiFePO_4$ + C Schicht bei Raumtemperatur ist die Schicht porenfrei (siehe Figur 3 links) (C beschreibt hier ganz allgemein Kohlenstoff). Erst bei Abscheidung bei erhöhten Temperaturen von beispielsweise 600 °C wird die Schicht porös (siehe Figur 3 rechts).

Die Porosität P einer Schicht in % kann wie folgt definiert werden:

$$P = (1 - \rho_{Schicht} / \rho_{theo.Dichte}) * 100$$

Hiermit ergibt sich im vorliegenden Fall (siehe Figur 3 rechts) eine Porosität P von etwa 70 %. Prinzipiell ist somit eine Schicht porös, sobald die Dichte geringer als die theoretische Dichte ist.

Die erfindungsgemäße, auf einem glatten Substrat abgeschiedene poröse Schicht wird hierbei durch ein sehr feingliedriges, faserartiges Netzwerk aufgebaut. Die einzelnen Fasern dieses Netzwerkes besitzen einen Durchmesser im nanoskaligen Bereich, das bedeutet von 10 bis 200 nm (siehe Figur 4, links). Das glatte Substrat ist poliert worden, wodurch eine glänzende (spiegelglatte) Oberfläche erreicht wurde.

Bei der Abscheidung auf etwas raueren Substraten, das bedeutet auf unpolierten Substraten mit matter Oberfläche, bildet sich ein weniger vernetztes poröses Netzwerk aus. In diesem Fall wachsen einzelne Fasern nahezu senkrecht nach oben. Die Fasern sind hier etwas dicker und haben einen Durchmesser im Bereich von 10 bis etwa 500 nm (siehe Figur 4, rechts).

Die Erzeugung der hier gezeigten Faserstrukturen und -netzwerke ist vorteilhaft unabhängig vom Substratmaterial.

Ein vergleichbares Verhalten, d. h. erst bei höheren Temperaturen stellt sich eine poröse Struktur ein, wurde bisher nur bei der Abscheidung von Metallen (Nickel, Gold, Silber, Aluminium, Zink) beobachtet. Siehe dazu auch A. F. Jankowski, and J. P. Hayes, Sputter deposition of a spongelike morphology in metal coatings, Journal of Vacuum Science & Technology A, 2003. 21(2): p. 422-425 und R. Gazia, et al., An easy method for the roomtemperature growth of spongelike nanostructured Zn films as initial step for the fabrication of nanostructured ZnO. Thin Solid Films, 2012. 524(0): p. 107-112. In einem bestimmten Druckbereich und bei einer Herstellungstemperatur, die etwa der Hälfte der Schmelztemperatur des Metalls entspricht, kann eine poröse Struktur beobachtet werden. Für nicht-metallische Materialien ist dieses Phänomen bisher nicht bekannt.

Alternativ können Nanostrukturen über Magnetron-Sputtern durch das Verfahren der glancing oder oblique angle deposition (OAD, GLAD) hergestellt werden (J. C. Sit, et al., Thin film microstructure control using glancing angle deposition by sputtering, Journal of Materials Research, 1999. 14(4): p. 1197-1199). Hierfür wird aber ein spezieller Aufbau benötigt, der geringere Abscheidungsraten zur Folge hat. Ferner wurde dieses Verfahren bisher nur für eine begrenzte Anzahl von Materialien umgesetzt (D. Manova, J. W. Gerlach und S. Mandl, Thin Film Deposition Using Energetic Ions. Materials, 2010. 3(8): p. 4109-4141.). Eine industrielle Umsetzbarkeit des Verfahrens erscheint nicht sinnvoll möglich.

Ausführungsbeispiel 1:

Durch das dieser Erfindung zugrunde liegende Verfahren ist es möglich, nanostrukturierte Lithiumeisenphosphat (LiFePO$_4$)-Elektroden mit additivem Kohlenstoff herzustellen, die als Kathodenmaterialien in Lithium-Ionen Batterien eingesetzt werden können. Als Ausgangsmaterial wurde ein LiFePO$_4$-Target, das zusätzlich 7 Gew.-% graphitischen Kohlenstoff enthält, verwendet. Das Target hat einen Durchmesser von 250 mm und der Abstand zum Substrat beträgt 55 mm. Zur Herstellung der nanostrukturierten Elektroden wurde eine Prozessleistung von 600 W angelegt. Dies entspricht einer Leistungsdichte von 1,2 W/cm$^2$. Als Prozessgas wurde Argon eingesetzt. Der Glasfluss betrug 20 sccm und der Prozessdruck 5 $*$ 10$^{-3}$ mbar. Die Substrattemperatur wurde auf 600 °C eingestellt. Unter diesen Bedingungen wird eine Abscheiderate von 0,3 mg/(cm$^2$*h) erreicht.

Die resultierende Nanostruktur umfassend LiFePO$_4$ ohne zusätzlichen Kohlenstoff nach einer Abscheidezeit von vier Stunden ist in den Figuren 3 rechts und 3 links dargestellt. Als Substrat wurde ein Titannitrid-beschichteter, thermisch oxidierter Siliziumwafer verwendet.

Die Herstellung des nanostrukturierten Elektrodenmaterials erfolgt mittels Magnetron-Kathodenzerstäubens, so dass als Grundvoraussetzung eine Prozesskammer benötigt wird, mit der dieses Verfahren durchgeführt werden kann. Bei diesem Verfahren wird ein Ausgangsmaterial durch Ionenbeschuss zunächst in die Gasphase überführt und anschließend auf einem Substrat kondensiert. Die Erzeugung der Ionen erfolgt über ein Prozessgas, dass durch eine angelegte Spannung ionisiert wird. Das Substrat befindet sich gegenüber dem Target, welches das abzuscheidende Elektrodenmaterial enthält. Eine Schrägstellung des Substrates gegenüber dem Target ist nicht erforderlich.

Die Figur 5 zeigt die Messkurve der elektrochemischen Aktivität der erfindungsgemäß hergestellten, nanostrukturierten Lithiumeisenphosphat (LiFePO$_4$)-Elektroden gemäß Ausführungsbeispiel 1 gegenüber einer metallischen Lithium-Anode. Als Elektrolyt wurde ein Flüssigelektrolyt, basierend auf LiPF$_6$, gelöst in einer 1:1 Mischung aus Ethylencarbonat und Dimethylcarbonat verwendet. Die hergestellte Zelle wurde mit einem Strom von 50 $\mu$A/cm$^2$ Ge- und Entladen im Spannungsbereich zwischen 2,8 V und 4,0 V. Die Messkurve belegt, dass die nanostrukturierte LiFePO$_4$ Elektrode das charakteristische Lade- und Entladeverhalten von LiFePO$_4$ besitzt. Dies ist daran zu erkennen, dass sich beim Laden und Entladen ein Spannungsplateau bei etwa 3,4 V ausbildet. Weiterhin zeigt sich, dass beim Laden und Entladen eine vergleichbare Kapazität erreicht wird, was einer hohen Reversibilität entspricht.

Dieses Beispiel zeigt, dass die netzartige poröse Nanostruktur bei einem nicht-metallischen Material (LiFePO$_4$) erzeugt werden konnte, welches vorteilhaft als Elektrodenmaterial für Lithium-Ionen Batterien genutzt werden kann.

Sofern dieses Verfahren auch auf andere nicht-metallische Materialien übertragen werden kann, könnte der Anwendungsbereich deutlich erweitert werden.

Als weitere geeignete Materialien für die Aufbringung als nanostrukturierte Schichten kommen prinzipiell alle Kathodenmaterialien (z. B. LiCoO$_2$, LiMn$_2$O$_4$, V$_2$O$_5$, LiMPO$_4$ + C (mit M = Ni, Co, Mn)) und Anodenmaterialien (C, Li$_4$Ti$_5$O$_{12}$) in Betracht. Insbesondere sind jedoch solche Materialien vielversprechend, die eine große Volumenschwankung während der Ein- und Auslagerung des Lithiums erfahren, wie z. B. Silizium.

Neben dem vorgenannten Anwendungsgebiet der Elektrodenherstellung könnte das erfindungsgemäße Verfahren aber auch bei weiteren Anwendungsbereichen interessant werden, beispielsweise bei der Herstellung von Wärmedämmschichten, Brennstoffzellen, Kondensatoren, optischen Filtern, Sensoren, magnetischen Speichern oder auch Katalysatoren.

Zusammenfassend lässt sich sagen, dass es für die Erzeugung der erfindungsgemäßen Nanostrukturierung grundlegend notwendig ist, dass die Prozessparameter Prozessleistung, Prozessgas, Prozessdruck, Gasfluß und Substrattemperatur gezielt eingestellt werden. Hierbei ist es vorteilhaft, dass der Prozessdruck auf ausreichend kleine Drücke (kleiner $5 * 10^{-2}$ mbar) eingestellt wird. Wesentlich ist eine Substrattemperatur, die ausreichend hoch eingestellt wird, insbesondre zwischen 400 und 1200 °C, und die Verwendung eines keramischen Targets mit einem Kohlenstoffanteil.

Das Besondere an der erfindungsgemäß hergestellten Elektrode im Rahmen dieser Erfindung sind in erster Linie nicht die elektrochemischen Eigenschaften, sondern dass die Elektrode eine poröse, netzförmige Nanostrukturierung aufweist, die mittels eines einfachen Magnetron-Sputterverfahrens in nur einem Prozessschritt hergestellt werden kann. Bisher werden Nanostrukturen oft über einen Lösungsmittel basierten Ansatz hergestellt, wie z. B. Solvothermalsynthese, Elektrodeposition oder Anodization. Diese Verfahren benötigen in der Regel mehrere Schritte und es werden zum Teil giftige Lösungsmittel/Ausgangsstoffe eingesetzt. Bei diesen Verfahren ist weiterhin ein Trocknungsschritt und zum Teil auch ein Kristallisationsschritt notwendig. Ferner werden zum Teil Masken eingesetzt, um die gewünschten Strukturen zu erhalten. Das Aufbringen und Entfernen der Masken erhöht den Zeitaufwand weiter.

Das Magnetron-Sputtern bietet den großen Vorteil, dass die fertige Elektrodenschicht in einem Schritt hergestellt werden kann. Es sind keine Vorbehandlungen (wie z. B. Aufbringen von Katalysatoren, Masken) und Nachbehandlung (wie z. B. Entfernen der Masken, Kristallisationsschritt, Trocknung) nötig. Ferner kann die Elektrode direkt auf einem Stromsammler abgeschieden werden, wodurch keine Binder oder weitere leitfähige Additive benötigt werden. Es werden keine giftigen Ausgangsstoffe benötigt und das Magnetron-Sputtern lässt sich auch auf große Substrate anwenden.

## Patentansprüche

1. Verfahren zur Herstellung einer nanostrukturierten Elektrode für eine elektrochemische Zelle,

    - bei dem Aktivmaterial mit Hilfe des Magnetron-Sputterns auf ein elektrisch leitendes Substrat aufgebracht wird,
    - bei dem ein keramisches Target, umfassend ein Elektrodenmaterial mit einem zusätzlichen Anteil an Kohlenstoff zwischen 0,1 und 25 Gew.-% eingesetzt wird, und
    - bei dem das Aktivmaterial in einem Prozessschritt auf das elektrisch leitende Substrat abgeschieden wird wobei das Substrat während der Abscheidung auf Temperaturen zwischen 400 °C und 1200 °C gehalten wird, und sich während der Abscheidung ein faserartiges poröses Netzwerk ausbildet.

2. Verfahren nach Anspruch 1,
   bei dem als Aktivmaterial $LiFePO_4$, $Li_4Ti_5O_{12}$, Lithiummetalloxide vom Typ $LiM_xO_2$ mit M = Co, Ni, Mn, Al, $LiMn_2O_4$ -Spinelle, auch teilsubstituiert, Lithiummetallphosphate vom Typ $LiMPO_4$ mit Fe, Mn, Co, V, auch teilsubstituiert, $V_2O_5$ oder Konversionsmaterialien wie $FeF_3$ eingesetzt wird.

3. Verfahren nach einem der Ansprüche 1 bis 2,
   bei dem der zusätzliche Anteil an Kohlenstoff im Target zwischen 2 und 7 Gew.-% beträgt.

4. Verfahren nach einem der Ansprüche 1 bis 3,
   bei dem als Arbeitsgas Argon, Argon/ Sauerstoff, Argon/Stickstoff, Argon/Wasserstoff oder Argon/Kohlenwasserstoffe eingesetzt wird.

5. Verfahren nach einem der Ansprüche 1 bis 4,
   bei dem in der Prozesskammer eine Leistungsdichte von 0,5 bis 2 $W/cm^2$ eingestellt wird, insbesondere eine Leistungsdichte von 1,0 bis 1,5 $W/cm^2$.

6. Verfahren nach einem der Ansprüche 1 bis 5,
   bei dem in der Prozesskammer ein Gasfluss von $8,3 \times 10^{-8}$ bis $83 \times 10^{-8}$ $m^3$ $s^{-1}$ (5 bis 50 sccm) eingestellt wird, insbesondere ein Gassfluss von $16,7 \times 10^{-8}$ $m^3$ $s^{-1}$ bis $41,7 \times 10^{-8}$ $m^3$ $s^{-1}$ (10 bis 25 sccm).

7. Verfahren nach einem der Ansprüche 1 bis 6,
   bei dem in der Prozesskammer eine Abscheiderate von 0,1 bis 1 $mg \cdot h/cm^2$ eingestellt wird, insbesondere eine Abscheiderate von 0,2 bis 0,5 $mg \cdot h/cm^2$.

8. Verfahren nach einem der Ansprüche 1 bis 7,
   bei dem eine Abscheidezeit zwischen 10 Minuten und 10 Stunden eingestellt wird, insbesondere zwischen 1 und 5 Stunden.

**Claims**

1.  Method for producing a nanostructured electrode for an electrochemical cell,

    - in which active material is applied to an electrically conductive substrate using magnetron sputtering,
    - in which a ceramic target, comprising an electrode material with an additional proportion of carbon between 0.1 and 25% by weight is used, and
    - in which the active material is deposited on the electrically conductive substrate in a process step,

    in which
    the substrate is kept at temperatures between 400° C and 1200° C during deposition, and a fibre-type porous network forms during deposition.

2.  Method according to claim 1,
    in which $LiFePO_4$, $Li_4Ti_5O_{12}$, lithium metal oxides of the $LiM_xO_2$ type with M = Co, Ni, Mn, Al, $LiMn_2O_4$ spinels, also partially substituted, lithium metal phosphates of the $LiMPO_4$ type with Fe, Mn, Co, V, also partially substituted, $V_2O_5$ or conversion materials such as $FeF_3$ are used as active material.

3.  Method according to one of claims 1 to 2,
    in which the additional proportion of carbon in the target is between 2 and 7% by weight.

4.  Method according to one of claims 1 to 3,
    in which argon, argon/oxygen, argon/nitrogen, argon/hydrogen or argon/hydrocarbons are used as working gas.

5.  Method according to one of claims 1 to 4,
    in which a power density of 0.5 to 2 $W/cm^2$ is set in the processing chamber, particularly a power density of 1.0 to 1.5 $W/cm^2$.

6.  Method according to one of claims 1 to 5,
    in which a gas flow of $8.3 \times 10^{-8}$ to $83 \times 10^{-8}$ $m^3$ $s^{-1}$ (5 to 50 sccm) is set in the processing chamber, particularly a gas flow of $16.7 \times 10^{-8}$ $m^3$ $s^{-1}$ to $41.7 \times 10^{-8}$ $m^3$ $s^{-1}$ (10 to 25 sccm).

7.  Method according to one of claims 1 to 6,
    in which a deposition rate of 0.1 to 1 mg • $h/cm^2$ is set in the processing chamber, particularly a deposition rate of 0.2 to 0.5 mg • $h/cm^2$.

8.  Method according to one of claims 1 to 7,
    in which a deposition time between 10 minutes and 10 hours is set, particularly between 1 and 5 hours.

**Revendications**

1.  Procédé de production d'une électrode nanostructurée d'une pile électrochimique,

    - dans lequel on dépose de la matière active sur un substrat conducteur de l'électricité à l'aide de la pulvérisation cathodique par magnétron,
    - dans lequel on utilise une cible en céramique, comprenant une matière d'électrode ayant une proportion supplémentaire de carbone comprise entre 0,1 et 25% en poids et
    - dans lequel on dépose la matière active dans un stade opératoire sur le substrat conducteur de l'électricité,

    dans lequel on maintient le substrat, pendant le dépôt, à des températures comprises entre 400°C et 1200°C et il se constitue, pendant le dépôt, un réseau poreux de type fibreux.

2.  Procédé suivant la revendication 1,
    dans lequel on utilise, comme matière active, $LiFePO_4$, $Li_4Ti_5O_{12}$, des oxydes métalliques de lithium du type $LiM_xO_2$ avec M = Co, Ni, Mn, Al, spinelle de $LiMn_2O_4$, également partiellement substitués, des phosphates métalliques de lithium du type $LiMPO_4$ avec M=Fe, Mn, Co, V, également partiellement substitués, $V_2O_5$ ou des matériaux de conversion, comme $FeF_3$.

**EP 3 308 417 B1**

**3.** Procédé suivant l'une des revendications 1 à 2,
dans lequel la proportion supplémentaire de carbone dans la cible est comprise entre 2 et 7% en poids.

**4.** Procédé suivant l'une des revendications 1 à 3,
dans lequel on utilise comme gaz de travail, de l'argon, de l'argon/oxygène, de l'argon/azote, de l'argon/hydrogène ou de l'argon/hydrocarbures.

**5.** Procédé suivant l'une des revendications 1 à 4,
dans lequel on règle, dans la chambre de processus, une densité de puissance de 0,5 à 2W/cm$^2$, notamment une densité de puissance de 1,0 à 1,5W/cm$^2$.

**6.** Procédé suivant l'une des revendications 1 à 5,
dans lequel on règle, dans la chambre de processus, un flux gazeux de 8,3x10$^{-8}$ à 83x10$^{-8}$ m$^3$ s$^{-1}$ (5 à 50 sccm), notamment un flux gazeux de 16,7x10$^{-8}$ m$^3$ s$^{-1}$ à 41,7x10$^{-8}$ m$^3$ s$^{-1}$ (10 à 25 sccm) .

**7.** Procédé suivant l'une des revendications 1 à 6,
dans lequel on règle, dans la chambre de processus, une vitesse de dépôt de 0,1 à 1 mg.h/cm$^2$, notamment une vitesse dépôt de 0,2 à 0,5 mg.h/cm$^2$.

**8.** Procédé suivant l'une des revendications 1 à 7,
dans lequel on règle un temps de dépôt compris entre 10 minutes et 10 heures, notamment entre 1 et 5 heures.

11

Übergangsstruktur
bestehend aus dichtgepackten, faserartigen
Körnern

Säulenförmige Körner

Poröse Struktur bestehend
aus kegelförmigen
Kristalliten, die durch
Hohlräume getrennt werden

Rekristallisierte
Kornstruktur

ZONE III

ZONE II

ZONE I

ZONE T

1.0
0.9
0.8
0.7
0.6
0.5
0.4
0.3
0.2
0.1

30

20

10

1

Argondruck
(m Torr)

Substrattemperatur $(T/T_M)$

## Figur 1 (Stand der Technik)

$LiFePO_4$

TiN

$Si/SiO_2$

400 nm

## Figur 2

**Figur 3**

**Figur 4**

**Figur 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 103000879 B
- DE 102009034799 A1
- CN 103579623 A


**In der Beschreibung aufgeführte Nicht-Patentliteratur**

- Template-free reverse micelle process for the synthesis of a rod-like LiFePO4/C composite cathode material for lithium batteries. **B.-J. HWANG et al.** Journal of Power sources. Elsevier, 20. Oktober 2009, vol. 194, 515-519
- **B. L. ELLIS ; P. KNAUTH ; T. DJENIZIAN.** Three-dimensional self-supported metal oxides for advanced energy storage. *Advanced Materials,* 2014, vol. 26 (21), 3368-3397
- **P. J. KELLY ; R. D. ARNELL.** Magnetron sputtering: a review of recent developments and applications. *Vacuum,* Marz 2000, vol. 56 (3), 159-172
- **THORNTON, J. A.** Influence of substrate temperature and deposition rate on structure of thick sputterd Cu coatings. *Journal of Vacuum Science & Technology,* 1975, vol. 12 (4), 830-835
- **J. C. SIT ; D. VICK ; K. ROBBIE ; M. J. BRETT.** Thin film microstructure control using glancing angle deposition by sputtering. *Journal of Materials Research,* vol. 14 (04), 1197-1199
- Preparation of RF-sputtered lithium cobalt oxide nanorods by using porous anodic alumina (PAA) template. **C. L. LIAO et al.** JOURNAL OF ALLOYS AND COMPOUNDS. ELSEVIER SEQUOIA, 13. April 2006, vol. 414, 302-309
- **J. A. THORNTON.** Influence of substrate temperature and deposition rate on structure of thick sputtered Cu coatings. *Journal of Vacuum Science & Technology,* 1975, vol. 12 (4), 830-835
- **MAHIEU, S. et al.** Biaxial alignment in sputter deposited thin films. *Thin Solid Films,* 2006, vol. 515 (4), 1229-1249
- **A. F. JANKOWSKI ; J. P. HAYES.** Sputter deposition of a spongelike morphology in metal coatings. *Journal of Vacuum Science & Technology A,* 2003, vol. 21 (2), 422-425
- **R. GAZIA et al.** An easy method for the roomtemperature growth of spongelike nanostructured Zn films as initial step for the fabrication of nanostructured ZnO. *Thin Solid Films,* 2012, vol. 524 (0), 107-112
- **J. C. SIT et al.** Thin film microstructure control using glancing angle deposition by sputtering. *Journal of Materials Research,* 1999, vol. 14 (4), 1197-1199
- **D. MANOVA ; J. W. GERLACH ; S. MANDL.** Thin Film Deposition Using Energetic Ions. *Materials,* 2010, vol. 3 (8), 4109-4141